# EUROPÄISCHE PATENTSCHRIFT

(11) **EP 0 284 855 B1**
(45) Veröffentlichungstag und Bekanntmachung des Hinweises auf die Patenterteilung: **22.12.1993**
(21) Anmeldenummer: 88103811.1
(22) Anmeldetag: 10.03.1988
(51) Int. Cl.: H01R 23/66

(54) **Kontaktiervorrichtung und Verfahren zum Anschluss einer Leiterfolie**
Contact device and process for connecting a conducting foil
Dispositif de contact et procédé de connexion d'un ruban conducteur

(30) Priorität: 31.03.1987 DE 3710593
(43) Veröffentlichungstag der Anmeldung: 05.10.1988
(73) Patentinhaber: Siemens Nixdorf Informationssysteme Aktiengesellschaft, 33102 Paderborn (DE)
(72) Erfinder: Dubois, Dieter, Dipl.-Ing., D-8900 Augsburg 21 (DE); Breite, Helge, B-04700 Eupen (BE)
(74) Vertreter: Fuchs, Franz-Josef, Dr.-Ing.

(56) Entgegenhaltungen:
- EP-A- 0 194 758
- US-A- 3 941 448

## Beschreibung

Die Erfindung betrifft eine Kontaktiervorrichtung und ein Verfahren zum automatischen Kontaktieren unter Verwendung dieser Kontaktiervorrichtung nach den Oberbegriffen der Patentansprüche 1 und 6.

Sehr häufig macht es nicht nur die Geometrie eines elektrischen Gerätes erforderlich, die für die Funktion des Gerätes notwendigen Bauteile auf mehrere Baugruppen zu verteilen. Auch geben die Vorzüge der modularen Aufbauweise Anregungen dafür, einen seinem Wesen nach zusammengehörigen Funktionskomplex auf einer vom Rest der Schaltung physikalisch leicht abtrennbaren und somit schnell auswechselbaren Baugruppe zu realisieren.

Dazu muß jede die Baugruppe verlassende elektrische Leitung über eine Kontaktiervorrichtung unterbrechbar und wieder verbindbar sein. Im allgemeinen werden zu diesem Zweck Mehrfachsteckverbinder benützt, die aus einer Stecker- und einer Buchsenleiste mit jeweils einer Vielzahl von Kontaktelementen bestehen. Um mit diesen Mehrfachsteckverbindern zwei Baugruppen elektrisch, z.B. über ein Kabel miteinander zu verbinden, sind insgesamt zwei Stecker- und zwei Buchsenleisten erforderlich.

Der nicht unerhebliche Kostenfaktor einer derartigen Steckverbindung gab zu der Sparmaßnahme Anlaß, die Leiterplatte der Baugruppe als Steckerleiste zu verwenden. Dazu sind alle die Baugruppe verlassenden Leitungen in Form von streifenförmigen, parallel zueinander an der Leiterplattenoberfläche verlaufenden Leiterbahnen an eine Kante der Leiterplatte geführt. Die Buchsenleiste wird durch eine Federleiste ersetzt, die den streifenförmigen Leiterbahnen zugeordnete Kontaktfedern aufweist und auf die Kante der Leiterplatte aufgesteckt wird.

Eine weitere Maßnahme zur Kostenverringerung besteht darin, das Kabel einer der Baugruppen zuzuordnen und an dieser direkt, d.h. ohne lösbare Steckverbindung zu befestigen. Allerdings ist für die direkte Anbindung eines Kabels an eine Baugruppe ein hoher fertigungstechnischer Aufwand erforderlich, der oft die Kosten der ersparten Steckverbindung aufwiegt.

Erst mit der Entwicklung von Leiterfolien, die eine flexible, einem Kabel ähnliche Leiterführung ermöglichen, stellt die direkte Anbindung eine ideale Lösung dar. Die Funktion einer Leiterplatte und die eines Kabels können in einer einzigen Leiterfolie vereint werden. So erfüllt z.B. eine Teilfläche der Leiterfolie die Funktion einer Leiterplatte und eine andere, meistens als Laschenansatz erkennbare Teilfläche die Funktion eines Kabels.

Eine lösbare elektrische Verbindung zwischen der Leiterfolie und einer Flachbaugruppe kann nun wiederum mit Hilfe eines aus Stecker- und Buchsenleiste bestehenden elektrischen Verbinders, oder durch, wie oben beschrieben, an eine Kante des Laschenansatzes geführte Leiterbahnen mit der zugehörigen Federleiste, hergestellt werden.

Ein entscheidendes Problem zeigt sich aber beim Einsatz der zweiten, kostengünstigeren Ausführung in Fertigungseinrichtungen, die eine automatische Montage der Geräte vorsieht. Durch das flexible Verhalten des Laschenansatzes ist nämlich ein kraftschlüssiges Aufstecken der Federleiste bisher nur manuell zu bewirken.

Aus der WO-A-86/033 45 ist eine elektrische Verbindungsvorrichtung bekannt, die aus einem Federleistengehäuse mit einer daran vertikal verschiebbar gelagerten Längsrippe besteht. Eine Kontaktierung erfolgt durch Einführen eines Flachbandkabels in das Federleistengehäuse, in das anschließend die Längsrippe zum Andrücken des Flachbandkabels an im Federleistengehäuse angeordnete Kontaktelemente eingebracht wird.

Aufgabe der vorliegenden Erfindung ist es, eine lösbare elektrische Verbindung zur Kontaktierung einer Federleiste mit einer an einer Tragefläche anliegenden Leiterfolie mit möglichst wenig Aufwand so weiterzubilden, daß eine automatische Kontaktierung möglich ist.

Gelöst wird die Aufgabe erfindungsgemäß durch die im kennzeichnenden Teil des Patentanspruchs 1 angegebenen Merkmale.

Vorteilhafte Weiterbildungen und ein Verfahren zum automatischen Kontaktieren sind in den Unteransprüchen angegeben.

Anhand der Zeichnung wird im folgenden ein Ausführungsbeispiel näher erläutert. Dabei zeigen
FIG 1 eine perspektivische Darstellung einer erfindungsgemäßen Kontaktiervorrichtung für eine auf einer Tragefläche befestigte Tastaturschaltfolie und eine eine Federleiste aufweisende Flachbaugruppe.
FIG 2 einen Querschnitt der erfindungsgemäßen Kontaktiervorrichtung nach FIG 1 mit einer von der folienfreien Seite der Tragefläche her aufgesteckten Federleiste.

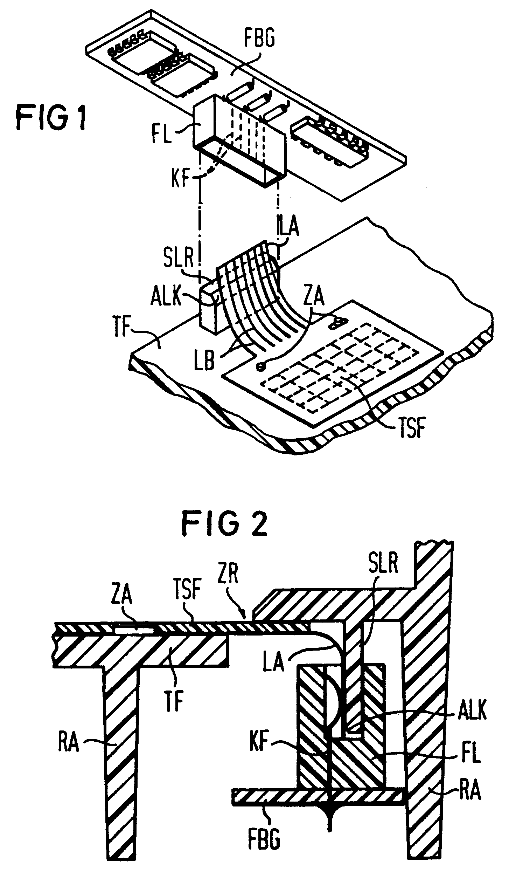

In FIG 1 ist eine Tragefläche TF mit einer streifenförmigen Längsrippe SLR dargestellt, an die sich ein rechteckförmiger Laschenansatz LA einer auf der Tragefläche TF befestigten Tastaturschaltfolie TSF federnd anlehnt. Weiterhin ist eine Flachbaugruppe FBG mit einer Federleiste FL abgebildet, deren Zuordnung zur streifenförmigen Längsrippe SLR der Tragefläche TF angedeutet ist.

Die Tastaturschaltfolie TSF liegt auf der als Bodenfläche dienenden Tragefläche TF auf. Zwei aus der Tragefläche TF herausstehende Zapfen ZA rasten in entsprechende Aussparungen der Tastaturschaltfolie TSF ein und fixieren diese auf der Tragefläche TF. Auf den Laschenansatz LA der Tastaturschaltfolie TSF sind auf der von der Tragefläche TF abgewandten Seite eine Vielzahl von parallelen, streifenförmigen Leiterbahnen LB geführt und enden im rechten Winkel an der Stirnkante des rechteckförmigen Laschenansatzes LA.

Die streifenförmige Längsrippe SLR befindet sich auf der die Tastaturschaltfolie TSF tragenden Seite der Tragefläche TF und ist senkrecht zur Trageflächenebene an der Tragefläche TF derart befestigt, daß der Laschenansatz LA aus der Trageflächenebene gedrängt werden kann. Dazu verläuft die streifenförmige Längsrippe SLR parallel zur Stirnkante des rechteckförmigen Laschenansatzes LA und stemmt sich mit einer vorteilhafterweise angeschrägten Längskante ALK, an die zur Tragefläche TF weisende Seite des Laschenansatzes LA an.

Die für die elektrische Kontaktierung der auf dem Laschenansatz LA herausgeführten Leiterbahnen LB vorgesehene Federleiste FL hat die Form einer länglichen Wanne, in deren Innenraum die streifenförmige Längsrippe SLR formschlüssig einführbar ist. In einer Längswandung der Federleiste FL sind eine Anzahl, in den Innenraum gerichteter Kontaktfedern KF enthalten, die für die elektrische Kontaktierung der Leiterbahnen LB des Laschenansatzes LA vorgesehen sind.

Beim Aufstecken der Federleiste FL auf die streifenförmige Längsrippe SLR und den sich an diese anlehnenden Laschenansatz LA bildet die abgeschrägte Längskante ALK eine Anlaufschräge für die Kontaktfedern KF, die dadurch mit geringerem Kraftaufwand in die Längswandung der Federleiste FL gedrängt werden können, so daß letztere leichter aufsteckbar ist. Die Kontaktfedern KF werden von der Stirnkante des Laschenansatzes LA noch weiter zurückgedrängt und drücken sich gegen die Leiterbahnen LB des Laschenansatzes LA, der sich dadurch an die streifenförmige Längsrippe SLR anschmiegt und zwischen dieser und den Kontaktfedern KF der Federleiste FL eingeklemmt wird.

In FIG 2 sind im Querschnitt gezeichnet die Tragfläche TF und die streifenförmige Längsrippe SLR dargestellt, die jeweils an einem von zwei sich gegenüberliegenden Seitenteilen eines gemeinsamen Rahmens RA, voneinander durch einen spaltartigen Zwischenraum ZR beabstandet, angebracht sind.

Die Tastaturschaltfolie TSF liegt auf der Tragefläche TF auf und wird durch den Zapfen ZA fixiert. Da die streifenförmige Längsrippe SLR im Gegensatz zu der in FIG 1 dargestellten, in Richtung der folienfreien Seite der Tragefläche TF weist, drängt sie demzufolge den Laschenansatz auch in dieser Richtung aus der Ebene der Tragefläche TF heraus. Dazu ist die streifenförmige Längsrippe SLR vom Rand der Tragefläche TF so beabstandet, daß sich der spaltförmige Zwischenraum ZR bildet, durch den der Laschenansatz LA an die streifenförmige Längsrippe SLR gelangt.

Eine Kontaktierung der Tastaturschaltfolie TSF mit der Flachbaugruppe FBG kann in drei Schritten vollautomatisch erfolgen.

In einem ersten Schritt wird die Tastaturschaltfolie TSF eventuell in einem spitzen Winkel zur Tragefläche TF mit ihrem Laschenansatz LA durch den spaltförmigen Zwischenraum ZR hindurch an die streifenförmige Längsrippe SLR angelegt. Im zweiten Schritt wird die Tastaturschaltfolie TSF auf die Tragefläche TF abgesenkt, so daß die Zapfen ZA in den Aussparungen einrasten. Im letzten Schritt wird die Flachbaugruppe FBG von der folienfreien Seite der Tragefläche TF her mit einer senkrecht zur Tragefläche TF verlaufenden Bewegungsrichtung zur streifenförmigen Längsrippe SLR geführt und die Federleiste FL auf die streifenförmige Längsrippe SLR und den sich an diese anlehnenden Laschenansatz LA gesteckt.

## Patentansprüche

1. Kontaktiervorrichtung zum elektrischen Verbinden einer an einer Tragefläche (TF) anliegenden Leiterfolie mit einer Federleiste (FL), bei der ein mit der Leiterfolie verbundener Laschenansatz (LA) wenigstens an einer Seite eine Anzahl elektrischer Kontaktflächen aufweist, denen jeweils einzelne Kontaktfedern (KF) der Federleiste (FL) zugeordnet sind,
**gekennzeichnet durch** eine gegenüber der Tragefläche (TF) starr angeordnete, den Laschenansatz (LA) aus der Ebene der Tragefläche (TF) herausdrängende streifenförmige Längsrippe (SLR), an die sich der Laschenansatz (LA) beim Andruck der Kontaktfedern (KF) anschmiegt.

2. Kontaktiervorrichtung nach Anspruch 1, **dadurch gekennzeichnet**, daß die Tragefläche (TF) und die streifenförmige Längsrippe (SLR) durch einen gemeinsamen Rahmen (RA) fixiert und räumlich so einander zugeordnet sind, daß zwischen Tragefläche (TF) und der streifenförmigen Längsrippe (SLR) ein spaltförmiger Zwischenraum (ZR) zum Einführen des Laschenansatzes (LA) verbleibt.

3. Kontaktiervorrichtung nach Anspruch 1 oder 2, **gekennzekennzeichnet durch** eine auf die streifenförmige Längsrippe (SLR) formschlüssig aufsteckbare Federleiste (FL).

4. Kontaktiervorrichtung nach Anspruch 3, **dadurch gekennzeichnet**, daß die streifenförmige Längsrippe (SLR) wenigstens an einer sich am Laschenansatz (LA) abstemmenden Längskante (ALK) angeschrägt ist.

5. Kontaktiervorrichtung nach Anspruch 4, **dadurch gekennzeichnet**, daß die Federleiste (FL) an einer Flachbaugruppe (FBG) befestigt ist.

6. Verfahren zum automatischen Kontaktieren unter Verwendung der Kontaktiervorrichtung nach einem der Ansprüche 1 bis 5, **dadurch gekennzeichnet**, daß zuerst der Laschenansatz (LA) der Leiterfolie (TSF) an die streifenförmige Längsrippe (SLR) angelegt und dann die Leiterfolie (TSF) auf der Tragefläche (TF) befestigt wird und daß danach der Laschenansatz (LA) zwischen der streifenförmigen Längsrippe (SLR) und den Kontaktfedern (KF) der Federleiste (FL) eingeklemmt wird.

7. Verfahren zum automatischen Kontaktieren nach Anspruch 6, **dadurch gekennzeichnet**, daß bei Verwendung einer Kontaktiervorrichtung nach den Ansprüchen 2 bis 5 der Laschenansatz (LA) durch den spaltförmigen Zwischenraum (ZR) hindurch an die streifenförmige Längsrippe (SLR) angelegt und die Federleiste (FL) mit der Flachbaugruppe (FBG) von der folienfreien Seite der Tragefläche (TF) her auf die streifenförmige Längsrippe (SLR) aufgesteckt wird.

## Claims

1. Contact-making device for the electrical connection of a conductor foil, which rests on a supporting surface (TF), to a female strip connector (FL), in the case of which a flap attachment (LA), which is connected to the conductor foil, has a number of electrical contact surfaces on at least one side, to which contact surfaces individual contact springs (KF) of the female strip connector (FL) are in each case allocated, characterized by a strip-shaped longitudinal rib (SLR), which is arranged rigidly with respect to the supporting surface (TF), displaces the flap attachment (LA) out of the plane of the supporting surface (TF) and to which the flap attachment (LA) is closely joined when the contact springs (KF) are pressed on.

2. Contact-making device according to Claim 1, characterized in that the supporting surface (TF) and the strip-shaped longitudinal rib (SLR) are fixed by means of a common frame (RA) and are spatially associated with one another such that an intermediate space (ZR), in the form of a gap, remains between the supporting surface (TF) and the strip-shaped longitudinal rib (SLR) for the insertion of the flap attachment (LA).

3. Contact-making device according to Claim 1 or 2, characterized by a female strip connector (FL) which can be plugged onto the strip-shaped longitudinal rib (SLR) in a positively-locking manner.

4. Contact-making device according to Claim 3, characterized in that the strip-shaped longitudinal rib (SLR) has an incline on at least one longitudinal edge (ALK) which originates at the flap attachment (LA).

5. Contact-making device according to Claim 4, characterized in that the female strip connector (FL) is attached to a printed-circuit board assembly (FBG).

6. Method for making contact automatically using the contact-making device according to one of Claims 1 to 5, characterized in that the flap attachment (LA) of the conductor foil (TSF) is initially placed on the strip-shaped longitudinal rib (SLR) and the conductor foil (TSF) is then mounted on the supporting surface (TF), and in that, thereafter, the flap attachment (LA) is clamped in between the strip-shaped longitudinal rib (SLR) and the contact springs (KF) of the female strip connector (FL).

7. Method for making contact automatically according to Claim 6, characterized in that, when a contact-making device according to Claims 2 to 5 is used, the flap attachment (LA) is placed on the strip-shaped longitudinal rib (SLR), passing through the gap-shaped intermediate space (ZR), and the female strip connector (FL) together with the printed-circuit board assembly (FBG) is plugged onto the strip-shaped longitudinal rib (SLR) from the side of the supporting surface (TF) which is free of foil.

## Revendications

1. Dispositif de contact pour relier électriquement une feuille conductrice disposée sur une surface de support (TF), à une barrette à ressorts (FL), dans lequel une saillie (LA) en forme de patte, reliée à la feuille conductrice, comporte, au moins d'un côté, un nombre de surfaces de contact électrique, auxquelles sont associés respectivement des ressorts de contact individuels (KF) de la barrette à ressorts (FL),
caractérisé par une nervure longitudinale (SLR) en forme de bande, qui est disposée rigidement en vis-à-vis de la surface de support (TF), et qui fait ressortir la saillie (LA) en forme de languette hors du plan de la surface de support (KF), et contre laquelle la saillie (LA) en forme de patte s'applique sous l'effet de la pression appliquée par les ressorts de contact (KF).

2. Dispositif de contact suivant la revendication 1, caractérisé par le fait que la surface de support (TF) et la nervure longitudinale (SLR) en forme de bande sont fixées par un cadre commun (RA) et sont associées dans l'espace de telle sorte qu'entre la surface de support (TF) et la nervure longitudinale (SLR) en forme de bande subsiste un espace intercalaire (ZR) en forme de fente permettant l'introduction de la saillie (LA) en forme de patte.

3. Dispositif de contact suivant la revendication 1 ou 2, caractérisé par une barrette à ressorts (FL) qui peut être enfichée, selon une liaison par formes complémentaires, sur la nervure longitudinale (SLR) en forme de bande.

4. Dispositif de contact suivant la revendication 3, caractérisé par le fait que la nervure longitudinale (SLR) en forme de bande est biseautée au moins sur un bord longitudinal (ALK), qui s'appuie contre la saillie (LA) en forme de patte.

5. Dispositif de contact suivant la revendication 4, caractérisé par le fait que la barrette à ressorts (FL) est fixée à un module plat (FBG).

6. Procédé pour établir automatiquement un contact moyennant l'utilisation du dispositif de contact suivant l'une des revendications 1 à 5, caractérisé par le fait qu'on applique tout d'abord la saillie (LA) en forme de patte de la feuille conductrice (TSF) sur la nervure longitudinale (SLR) en forme de bande, puis qu'on fixe la feuille conductrice (TSF) sur la surface de support (TF) et qu'ensuite on serre la saillie (LA) en forme de patte entre la nervure longitudinale (SLR) en forme de bande et les ressorts de contact (KF) de la barrette à ressorts (FL).

7. Procédé pour établir automatiquement un contact suivant la revendication 6, caractérisé par le fait que, dans le cas de l'utilisation d'un dispositif de contact conforme aux revendications 2 à 5, on applique la saillie (LA) en forme de patte, à travers l'espace intercalaire (ZR) en forme de fente, contre la nervure longitudinale (SLR) en forme de bande et qu'on emmanche la barrette élastique (FL) équipée du module plat (FBG), à partir de la face, qui ne comporte pas la feuille, de la surface de support (TF), sur la nervure longitudinale (SLR) en forme de bande.
